**Europäisches Patentamt**

**European Patent Office**

**Office européen des brevets**

(19)

(11) Veröffentlichungsnummer: **0 217 193**
**B1**

(12)    # EUROPÄISCHE PATENTSCHRIFT

(45) Veröffentlichungstag der Patentschrift: **16.01.91**

(51) Int. Cl.⁵: **G 01 R 1/073,** G 01 R 31/28

(21) Anmeldenummer: **86112572.2**

(22) Anmeldetag: **11.09.86**

(54) **Halte- und Prüfvorrichtung für auf flache Träger aufgebrachte elektronische Bausteine.**

(30) Priorität: **20.09.85 DE 3533658**

(43) Veröffentlichungstag der Anmeldung:
**08.04.87 Patentblatt 87/15**

(45) Bekanntmachung des Hinweises auf die
Patenterteilung:
**16.01.91 Patentblatt 91/03**

(84) Benannte Vertragsstaaten:
**AT BE CH DE FR GB IT LI NL SE**

(56) Entgegenhaltungen:
**US-A-3 678 385**
**US-A-4 329 642**

(73) Patentinhaber: **Siemens Aktiengesellschaft**
**Wittelsbacherplatz 2**
**D-8000 München 2 (DE)**

(72) Erfinder: **Krause, Bernd**
**Krünertstrasse 8/II**
**D-8000 München 70 (DE)**

Courier Press, Leamington Spa, England.

**Beschreibung**

Die Erfindung betrifft eine Halte- und Prüfvorrichtung für auf flache Träger aufgebrachte elektronische Bausteine entsprechend dem Oberbegriff des Patentanspruches 1.

Auf Träger aufgebrachte elektronische Bausteine, zum Beispiel als Speicher oder Schaltkreise in integrierter Schaltkreistechnik, stellen in der Regel Zwischenprodukte dar, um die Bausteine auf ihre Funktionstüchtigkeit prüfen zu können, bevor sie zur Bestückung von Leiterplatten Verwendung finden.

Die Prüfung setzt aber voraus, daß die Anschlußbeine der Bausteine sehr genau ausgerichtet gegenüber einer Kontaktanordnung mit entsprechend verteilter Anordnung der Kontaktstifte gehalten werden. Dies könnte beispielsweise durch Fixierstifte einer Aufnahme geschehen, die in am Träger angebrachte entsprechende Bohrungen oder Einbuchtungen hineinragen und die Träger in horizontaler Ausrichtung fixieren, wenn der Träger eingelegt ist. An mit der Aufnahmeplatte verbundenen Führungsstangen ließe sich dann die Kontaktanordnung, von Hand oder pneumatisch gesteuert auf die Anschlußbeine absenken, so daß über die Kontaktstifte die erforderlichen Prüfverbindungen zu einem Prüfgerät oder einem Prüfrechner hergestellt werden.

Derartige Vorrichtungen zum Halten und Prüfen mit oberhalb des Trägers angeordneten Kontaktanordnungen lassen sich schlecht in Prüftische einbauen. Weiterhin erfordern sie einen einer kompakten Bauweise entgegenstehenden ausreichenden Hub der Kontaktanordnung, damit die Träger ohne weiteres in die Aufnahme eingelegt und aus dieser wieder entnommen werden können. Auch sind zusätzliche Sicherungsmaßnahmen erforderlich, damit die Kontaktanordnung nicht ausgelöst werden kann, wenn sich die Finger der Bedienungsperson noch zwischen dem zu prüfenden Baustein und der Kontaktanordnung befinden.

Aufgabe der Erfindung ist es daher, eine Halte- und Prüfvorrichtung zu schaffen, die einen kompakten einfachen Aufbau aufweist, von einer Seite her vollkommen frei ohne Behinderung durch die Kontaktanordnung zugänglich ist, einfach in ebene Prüftische eingesetzt und/oder an bewegliche Mehrfach-Koaxialstecker angebracht werden können.

Diese Aufgabe wird durch die kennzeichnenden Merkmale des Patentanspruches 1 gelöst.

Danach wird eine bewegliche Platte mit der Federkontaktanordnung von unten gegen eine mit einer Mulde als Aufnahme versehene Lochplatte bewegt. Neben der Kontaktanordnung sind in gleicher paralleler Ausrichtung Fixierstifte zur horizontalen Fixierung des Trägers an der beweglichen Platte befestigt, die wie die Kontaktstifte in entsprechenden Bohrungen der Lochplatte in axialer Richtung frei bewegbar sind und durch diese hindurchragen.

Außerdem sind in der beweglichen Lochplatte Führungsstifte in gleicher paralleler Ausrichtung befestigt, die in weiteren Bohrungen der Lochplatte in axialer Richtung frei bewegbar sind und mit ihren kegelförmigen Spitzen in Bohrungen von in die Lochplatte eingelassenen, horizontal verschiebbaren Schiebern eingreifen. An den Schiebern sind dem Träger zugewandte Zungen angebracht, die abhängig von der Vertikalbewegung der Führungsstifte seitlich über den in die Mulde zwischen den Fixierstiften eingelegten Träger gleiten und diesen in Verbindung mit den Fixierstiften lagerichtig fixieren, bevor durch eine weitere Bewegung der beweglichen Platten nach oben die Kontaktstifte die Verbindung mit den Anschlußbeinen des auf den eingelegten Träger angebrachten Bausteines herstellen.

Durch die Bewegung eines einzigen Stellgliedes, nämlich der beweglichen Platte mit den Fixier- und Führungsstiften, wird so in einfacher Weise eine Lagefixierung des Trägers und damit des zu prüfenden Bausteines erreicht. Der Hub der beweglichen Platte gegenüber der Lochplatte kann verhältnismäßig klein gehalten werden, da sich die beweglichen Teile auf der von der Bedienungsseite abgewandten Seite der Lochplatte befinden. Die Aufnahme für die Träger der zu prüfenden Bausteine ist daher von einer Seite her auch ungehindert zugänglich. Zusätzliche Sicherungsmaßnahmen zum Schutz der Bedienungsperson können entfallen.

Weiterbildungen der Erfindung bezüglich der Ausbildung der Lochplatte, der beweglichen Platte mit der die Verschiebung gegenüber der Lochplatte bewirkenden Stellvorrichtung sowie bezüglich weiterer anwendungsbezogener Konstruktionsmerkmale ergeben sich aus den Unteransprüchen.

Einzelheiten der Erfindung seien nachfolgend anhand eines in der Zeichnung dargestellten Ausführungsbeispieles näher erläutert. Im einzelnen zeigen:

FIG 1A einen Grundriß der Halte- und Prüfvorrichtung gemäß der Erfindung mit teilweise geschnittener Abdeckplatte,

FIG 1B eine erste Seitenansicht der Halte- und Prüfvorrichtung von FIG 1A in Richtung des Pfeiles B, teilweise geschnitten,

FIG 1C eine zweite Seitenansicht der Halte- und Prüfvorrichtung von FIG 1A in Richtung des Pfeiles C, ebenfalls teilweise geschnitten,

FIG 2A einen Grundriß eines Bausteinträgers für die Prüfung mit der Halte- und Prüfvorrichtung von FIG 1,

FIG 2B eine Seitenansicht des Bausteinträgers von FIG 2A,

FIG 3A bis 3C einen Grundriß der Lochplatte mit zwei Schnittansichten entlang der Schnittlinien 1-1 und 2-2,

FIG 4A bis 4C einen Grundriß der beweglichen Platte mit einer Schnittansicht entlang der Schnittlinie 1-1 und einer Seitenansicht in Blickrichtung des Pfeiles C in FIG 4A,

FIG 5A einen Grundriß des Tragringes von FIG 1B oder FIG 1C mit den Lagerungen für die Stellwelle,

FIG 5B einen Aufriß der Anordnung von FIG 5A mit der beweglichen Platte und der Lochplatte,

FIG 5C einen gegenüber dem von FIG 5B gedrehten Aufriß in Blickrichtung des Pfeiles C in FIG 5A,

FIG 6A und 6B Schnittansichten der einen Lagerung von FIG 5A entlang der Schnittlinie VI-VI in den beiden möglichen Raststellungen,

FIG 7A und 7B Schnittansichten der anderen Lagerung von FIG 5A entlang der Schnittlinie VII-VII,

FIG 8 eine Querschnittsansicht der Lochplatte in Anlehnung an FIG 3C und der beweglichen Platte entlang der Schnittlinie VIII-VIII von FIG 4A zur Erläuterung der Funktionsweise,

FIG 9 eine Schnittansicht zur Erläuterung der Befestigung der Federkontaktstifte und

FIG 10 eine Schnittansicht zur Erläuterung der Befestigung der Fixierstifte.

Bei dem gewählten Ausführungsbeispiel sind in allen Figuren gleiche Teile mit denselben Bezugszeichen versehen.

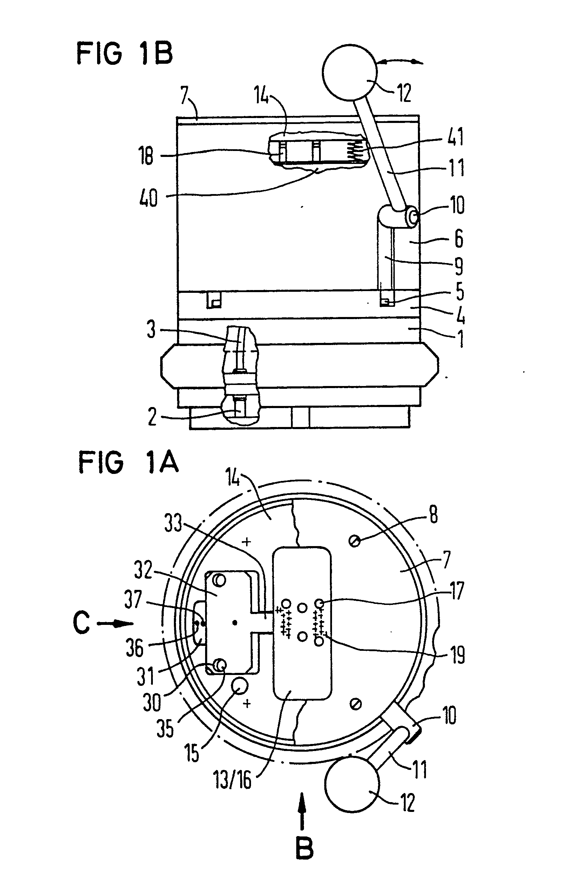

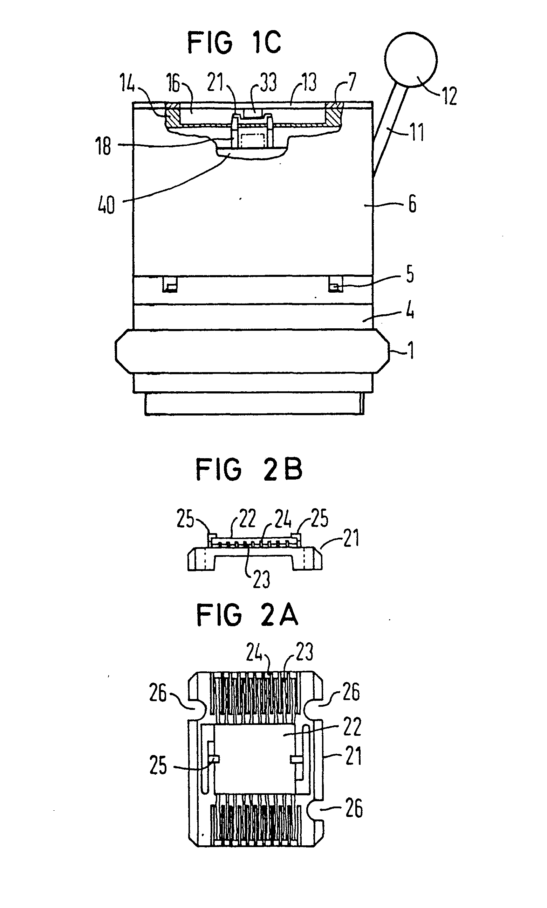

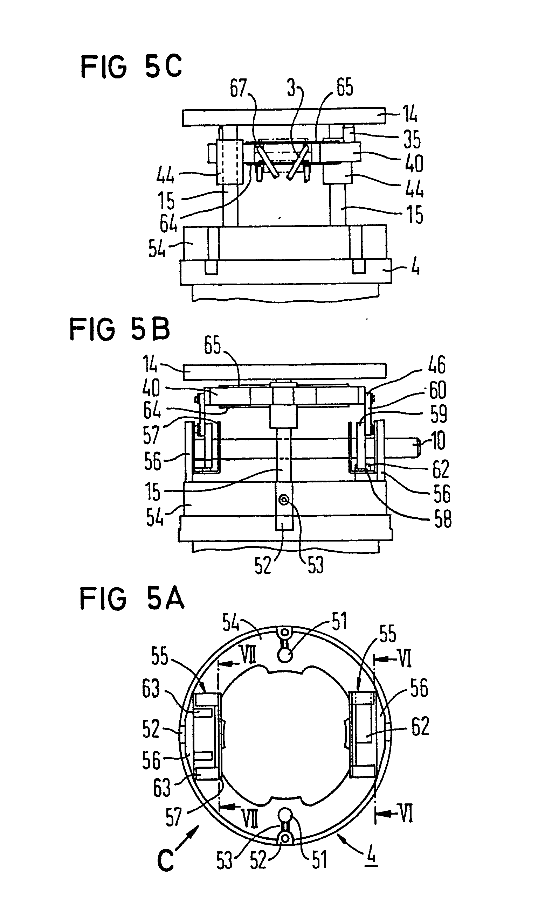

Wie aus den Figuren 1A bis 1C ersichtlich, handelt es sich bei dem gewählten Ausführungsbeispiel um eine eigenständige Halte- und Prüfvorrichtung, die auf ein handelsübliches Mehrfach-Koaxialverbindungs-Steckerteil 1 montiert ist, das beispielsweise 64 Steckerbuchsen aufweist, die in an sich bekannter Weise über Koaxialleitungen mit der Meßeinrichtung oder dem Prüfrechner verbunden werden können. Im Inneren sind die Steckerbuchsen 2 über Verbindungsleitungen 3 mit den einzelnen, in FIG 1 nicht gezeigten Federkontakten der Federkontaktanordnung im Inneren der Halte- und Prüfvorrichtung verbunden. An dem Mehrfach-Koaxialverbindungs-Steckerteil 1 ist ein an das Steckerteil angepaßter Trägerring 4 mit beispielsweise vier Schrauben 5, die am Umfang gleichmäßig verteilt sind, befestigt. Über einen Ansatz 54 (FIG 5) mit kleinerem Außendurchmesser ist eine Gehäusehülse 6 aufgeschoben, die am offenen Ende mit einer Abdeckplatte 7 abgedeckt ist, die wie aus FIG 1A ersichtlich, mit Schrauben 8 von einer darunterliegenden und vom Trägerring 4 gehaltenen Lochplatte 14 befestigt ist. In der Gehäusehülse 6 ist, wie aus FIG B ersichtlich, ein Schlitz 9 vorgesehen, so daß die Gehäusehülse 6 trotz der aus dem Innern herausragenden Stellwelle 10 ohne weiteres aufgeschoben werden kann. An der Welle 10 ist ein Hebel 11 mit Knauf 12 befestigt, der in Pfeilrichtung zum Bedienen der Halte- und Prüfvorrichtung zwischen zwei Raststellen hin- und herbewegt werden kann.

In der Abdeckplatte 7 und der darunter liegenden Lochplatte 14 ist, wie aus FIG 1A und FIG 1C ersichtlich, eine rechteckförmige Aussparung 13 bzw. eine der Aussparung entsprechende Vertiefung 16 vorgesehen, die als Aufnahme für den Träger 21 des zu prüfenden Bausteines dienen. In dieser Aufnahmemulde 13/16 wird der Träger 21 durch am freien Ende konisch zulaufende Fixierstifte 18 in seiner horizontalen Ausrichtung fixiert. Die freien Enden dieser Fixierstifte 18 ragen dazu durch Bohrungen 17 in der Lochplatte 14 hindurch. Neben den Bohrungen 17 sind weitere Bohrungen 19 entsprechend der Anordnung der einzelnen Anschlußbeine des zu prüfenden Bausteines vorgesehen, durch die Kontaktstifte frei beweglich die gewünschten elektrischen Verbindungen zum zu prüfenden Baustein herstellen.

FIG 2A und FIG 2B zeigen eine Draufsicht und eine Seitenansicht eines Trägers 21 mit aufgebrachtem Baustein 22, der durch Haltenasen 25 gehalten wird. Die sich zu beiden Seiten des Bausteines 22 erstreckenden Anschlußbeine 23 liegen in etwa in derselben Ebene wie der Baustein 22 und sind zwischen auf dem Träger 21 angebrachten Stegen 24 eingebettet. Der Träger weist außerdem an den beiden Längsseiten Einbuchtungen 26 zur Lagefixierung auf.

Zum Prüfen des auf einem solchen Träger 21 angebrachten Bausteines 22 wird der Träger auf dem Kopf in die Aufnahmemulde 13 und 16 so eingelegt, daß die Fixierstifte 18 mit ihren Enden in die seitlichen Einbuchtungen 26 am Träger 21 - wie aus FIG 1C ersichtlich eingreifen.

Damit der auf der Bodenfläche der Lochplatte 14 aufliegende Träger 21 beim Aufsetzen der Kontaktstifte auf die Kontaktbeine 23 des zu prüfenden Bausteines in vertikaler Richtung nicht ausweichen kann, sind in seitlichen Vertiefungen 31 der Lochplatte 14 zwei einander gegenüberliegende Schieber 32 vorgesehen, die innerhalb der Vertiefung 31 horizontal in Richtung der Aufnahmemulde 13/16 aufeinander zu verschiebbar sind. Auf der der Aufnahmemulde 13/16 zugewandten Seite weisen diese Schieber 32 Zungen 33 auf, die beim Verschieben der Schieber 32 über den Rükken des Trägers 21 gleiten und diesen daher in vertikaler Richtung ebenfalls fixieren.

Die Verschiebung der in die Lochplatte 14 eingelagerten Schieber 32 erfolgt mit Hilfe von Bohrungen 30, in die kegelförmige Spitzen von Führungsstiften 35 hineinragen. In der Ausgangsraststellung liegen die Spitzen der kegelförmig endenden Führungsstifte 35 an der Aufnahmemulde 13/16 zugewandten Innenkante der Bohrungen 30 an, so daß mit Anheben der Führungsstifte die Schräge der kegelförmigen Enden in Verbindung mit der Abdeckplatte 7 eine Seitwärtsbewegung der Schieber 32 bewirken. Diese Seitwärtsbewegung hält solange an, bis die Führungsstifte 35 eine konzentrische Lage zu den Bohrungen 30 in den Schiebern 32 erreicht haben, so daß die Führungsstifte 35 in den Bohrungen 34 ohne zusätzliche Seitwärtsverschiebung weitergleiten können. Koppelt man daher die Verschiebung der Führungsstifte 35 mit der Bewegung der Kontaktstifte der Kontaktanordnung zur Herstellung der elektrischen Verbindungen mit den Anschlußbeinen 23 des zu prüfenden Bausteines 22, so kann in einfacher Weise erreicht werden, daß die Kontaktstifte auf die Anschlußbeine 23 erst dann aufsetzen, wenn der in die Aufnahmemulde 13/16 eingelegte Träger in seiner räumlichen Lage durch die Zungen 33 des Schiebers 32 und die Fixierstifte 18 bereits vollständig fixiert ist.

Wie die FIG 1A weiterhin zeigt, ist innerhalb einer seitlichen Ausbuchtung der Vertiefung 31 für die Schieber 32 auf der der Zungenseite gegenüberliegenden Seite der Schieber 32 ein Zapfen 36 angebracht, an dem eine Zugfeder 37 befestigt ist. Diese Zugfeder 37 ist am anderen Ende mit dem Schieber 32 verbunden, so daß bei abnehmender Keilwirkung durch die Führungsstifte 35 die Schieber 32 wieder in die Ausgangslage überführt werden und dadurch den eingelegten Träger 21 freigeben.

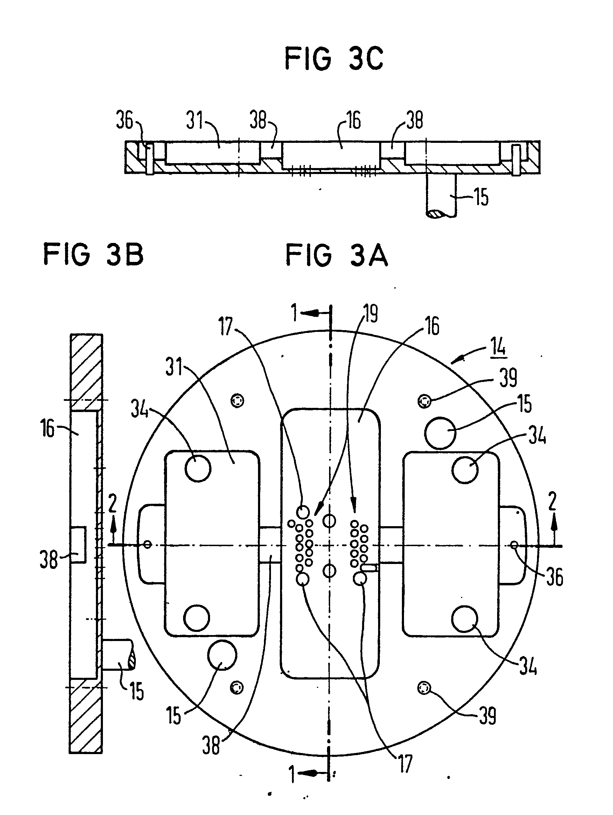

FIG 3 zeigt die Lochplatte 14 von FIG 1 in vergrößerter Darstellung ohne die teilweise Abdeckung durch die darüber liegende Abdeckplatte 7, während FIG 3B und 3C zwei dazugehörige Schnittansichten entlang der Schnittlinien 1-1 bzw. 2-2 zeigen. Insbesondere aus den Schnittansichten ist zusätzlich ersichtlich, daß die einzelnen Vertiefungen unterschiedliche Höhen aufweisen. Das gilt insbesondere für den Bereich 38 der an den Schiebern 32 angebrachten Zungen 33 und für den Bereich der Haltezapfen 36 für die Zugfeder 37. Die unterschiedlichen Höhen der Vertiefungen 16, 38 und 31 resultieren dabei in erster Linie aus der Anpassung der Zungenunterseite an die Höhe des zu haltenden Trägerrückens sowie in Anpassung an die Dimensionierung der Führungsstifte 35 mit ihren die Seitwärtsverschiebung der Schieber 32 bewirkenden Schrägflächen in Verbindung mit der Stärke der Lochplatte 14, damit die Führungsstifte 35 in ihrer oberen Endstellung die Oberkante der Lochplatte 14 nicht allzuweit überragen und damit andererseits nach Erreichen der Endstellung für die Schieber 32 noch ein ausreichender Hub für die Kontaktfederanordnung verbleibt. Zum andern liefert eine stärkere Vertiefung 31 für die Schieber gegenüber dem Bereich mit dem Haltezapfen 36 eine natürliche Anschlagkante für die Ruhestellung. Das gilt insbesondere, wenn abweichend von dem gewählten Ausführungsbeispiel der Schieber die gleiche Breite wie die Zungen aufweist und statt der jeweils parallel einwirkenden Führungsstifte 35 lediglich ein einziger Führungsstifte für jeden Schieber vorgesehen wird.

Wie aus den Figuren FIG 3A bis FIG 3C weiterhin ersichtlich ist, wird die Lochplatte 14 von zwei einander diagonal gegenüberliegenden Rundstäben 15 getragen, die mit der Lochplatte 14 starr verbunden sind, zum Beispiel durch einen Preßsitz. Diese Rundstäbe sind mit ihren anderen Enden in den Trägerring 4 von FIG 1 eingelassen, so daß zwischen der Lochplatte 14 und dem Trägerring 4 eine feste Verbindung besteht.

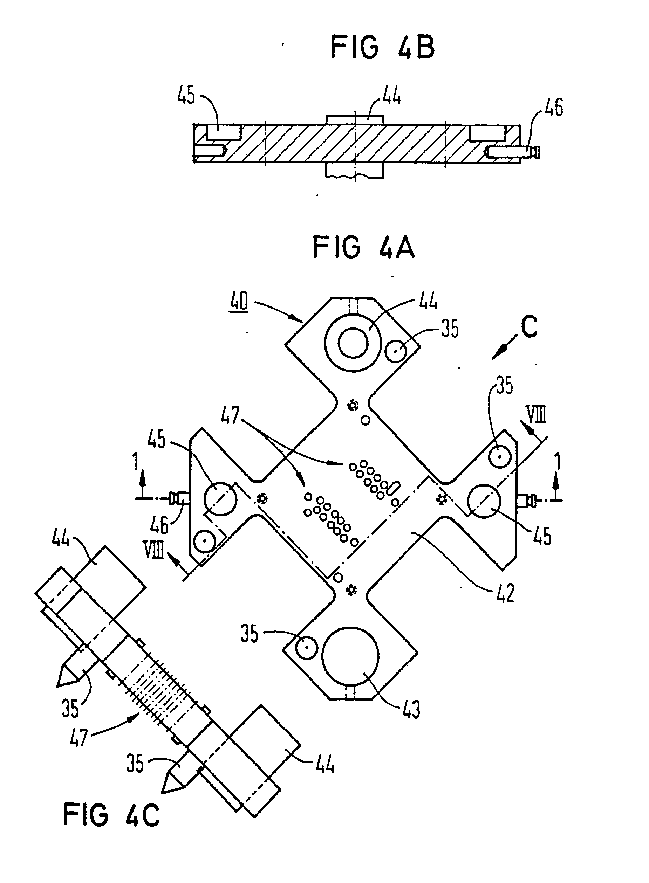

Die beiden Rundstäbe 15 bilden zugleich die Führungsstäbe für eine bewegliche Platte 40, die in FIG 4A bis FIG 4C näher dargestellt ist. Gemäß FIG 4A besteht diese Platte 40 aus einem mittleren, viereckigen Plattenteil 42 mit an den einzelnen Ecken angrenzenden Erweiterungen. In einem Paar der diagonal einander gegenüberliegenden Erweiterungen sind in Bohrungen 43 eingesetzte Linearkugellager 44 vorgesehen, mit deren Hilfe die Lochplatte an den in FIG 3 gezeigten Rundstäben 15 als Führungsstäbe entlang bewegt werden kann. Die an den beiden anderen Enden vorhandenen Erweiterungen sind dagegen mit kreisförmigen Vertiefungen 45 zur Aufnahme von Dämpfungsfedern 41 versehen, die - wie aus FIG 1B ersichtlich - zur Abfederung der beweglichen Platte 40 gegenüber der Lochplatte 14 dienen. Außerdem sind an diesen Erweiterungen seitlich Zapfen 46 angebracht, über die die Bewegung der Platte 40 gegenüber der Lochplatte 14 entlang der Führungsstäbe 15 herbeigeführt wird. Zusätzlich ist auf jeder Erweiterung einer der vier Führungsstifte 35 befestigt, wobei jeweils zwei Führungsstifte zusammenwirken. Im zentralen viereckigen Plattenteil befinden sich mit den Bohrungen in der Lochplatte von FIG 3 konzentrisch fluchtende Bohrungen 47 für die einzelnen Kontaktstifte und für die Befestigung der Fixierstifte 18.

FIG 4B zeigt eine zusätzliche Schnittansicht entlang der Schnittlinie 1-1 von FIG 4A zur weiteren Verdeutlichung der Aufnahmevertiefungen 45 für die Dämpfungsfedern und der Zapfen 46 für den Anschluß an ein Hebewerk, während FIG 4C eine Seitenansicht in Richtung des Pfeiles C von FIG 4A zeigt, die die kegelförmige Zuspitzung der Führungsstifte 35 eindeutig erkennen läßt.

Diese bewegliche Platte 40 wird entlang der Führungsstäbe 15, die zwischen dem Trägerring 4 und der Lochplatte 14 eingespannt sind, durch ein über die Welle 10 angetriebenes Hebewerk in senkrechter Richtung auf- und abbewegt. FIG 5 zeigt entsprechende Einzelheiten in Form von drei Teilfiguren entsprechend FIG 5A bis FIG 5C. FIG 5A zeigt dazu den Grundriß des Trägerringes 4 mit zwei daran befestigten Lagerungen 55 für die in diesem Falle nicht gezeigte Welle 10, mit den Aufnahmebohrungen 51 für die beiden Führungsstäbe 15 und den am Rande angebrachten Einbuchtungen 52 mit Bohrungen für die Befestigung am Steckerteil 1 durch die Schrauben 5. Die Führungsstäbe 15 werden dabei, wie aus FIG 5B ersichtlich, durch Madenschrauben in Gewindebohrungen 53 gehalten. Die innerhalb des Ansatzes 54 mit kleinerem Durchmesser angebrachten beiden Lagerungen 55 für die Welle 10 bestehen aus jeweils einem äußeren Lagerbock 56 und einem für das Einlegen der Welle nach oben hin geschlitzten Winkel 57, die mit Schrauben 58 am Trägerring 4 befestigt sind. An der Welle sind beidseitig Nockenscheiben 59 fest angebracht, die jeweils über eine an beiden Enden beweglich gelagerte Führungsstange 60 mit der beweglichen Platte 40 verbunden sind. Die Drehbewegung der Welle 10 kann somit in eine Verschiebung der beweglichen Platte 40 entlang der Führungsstäbe 15 umgesetzt werden.

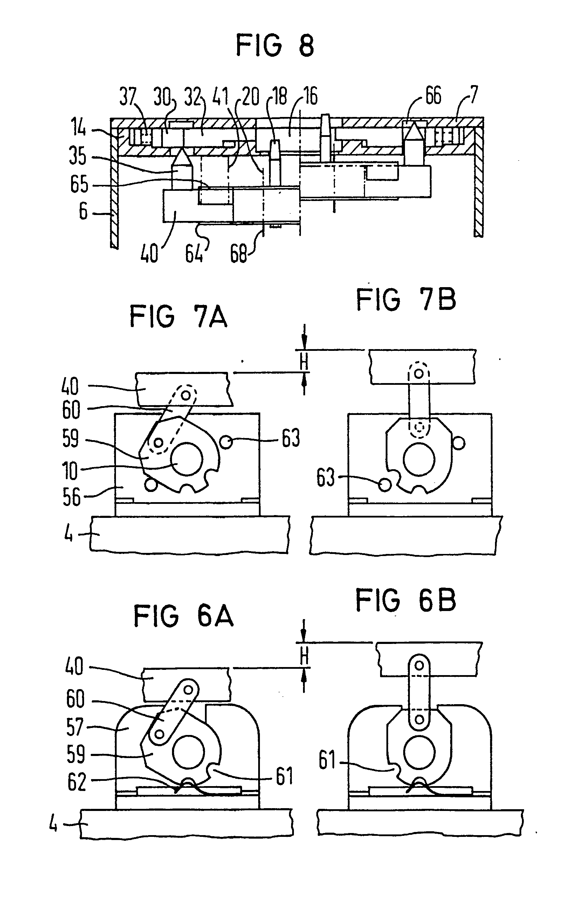

Weitere Einzelheiten bezüglich der von den Nockenscheiben 59 bewirkten Verschiebung der beweglichen Platte 40 ergeben sich aus FIG 6 und Fig 7 in Form von jeweils zwei Teilfiguren FIG 6A und FIG 6B bzw. FIG 7A und FIG 7B entsprechend den beiden möglichen Raststellungen. FIG 6A und FIG 6B zeigen dabei Schnittansichten der rechten Lagerung 55 in FIG 5A entlang der Schnittlinie VI-VI, wobei ersichtlich ist, daß am unteren Rand der Nockenscheibe zwei Rasteinbuchtungen 61 vorgesehen sind, in die ein entsprechend ausgeformter Teil einer Feder 62 rastend eingreift. Beim Übergang von der einen Raststellung in die andere Raststellung ergibt sich ein Hub H für die bewegliche Platte 40.

In analoger Weise zeigen FIG 7A und FIG 7B Schnittansichten der linken Lagerung 55 in FIG 5A entlang der Schnittlinie VII-VII. Wie hieraus ersichtlich, wird die Drehbewegung der Welle 10 durch zusätzliche Anschlagzapfen für die beiden Seitenkanten der Nocken 59 begrenzt. Die Feder 62 für die Markierung der Raststellungen und die Anschlagzapfen 63 für die Begrenzung der Drehbewegung können abweichend vom gezeigten Ausführungsbeispiel jeweils auch an beiden Lagerungen 55 vorgesehen werden.

FIG 5C zeigt einen weiteren Aufriß der Anordnung von FIG 5A aus der Blickrichtung des Pfeiles C, wobei jedoch die Lagerungen 55 weggelassen sind. Diese Blickrichtung entspricht der Ausrichtung der in FIG 3B gezeigten Schnittansicht der Lochplatte 14, um die Anbringung der in FIG 1B gezeigten Verbindungsleitungen 3 zu verdeutlichen.

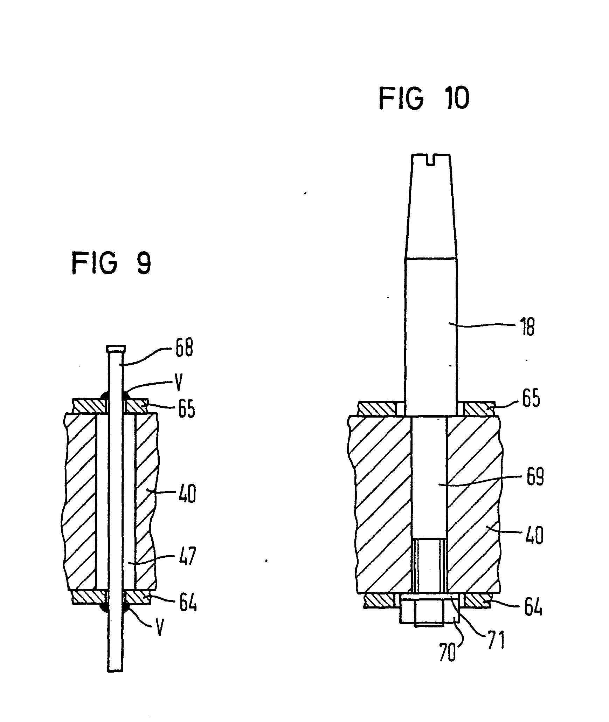

Wie aus FIG 5B und 5C ersichtlich, ist sowohl auf der Unterseite als auch auf der Oberseite der beweglichen Platte 40 jeweils eine Leiterplatte vorgesehen, die den zentralen viereckigen Plattenteil 42 der beweglichen Platte 40 überdeckt und entlang der Langsseiten dieses Plattenteiles zwischen den an den Ecken angrenzenden Erweiterungen über den Plettenteil 42 hinausragen. Im Bereich des zentralen viereckigen Plattenteiles 42 weisen diese gedruckten Leiterplatten 64 und 65 mit den Bohrungen 47 konzentrisch fluchtende Bohrungen auf, in die wie FIG 9 näher zeigt Hülsen 68 für die Kontaktfederstifte beidseitig eingelötet sind. Diese Lötstellen V sind über aufgedruckte Leiterbahnen mit Kontaktbohrungen im überstehenden Randbereich der beiden Leiterplatten verbunden, in die Koaxialkabelübergänge für die Verbindungsleitungen 3 eingelötet sind. Im Bereich der ebenfalls an der beweglichen Platte 40 befestigten Fixierstifte 18 sind, wie Fig 10 zeigt, in den Leiterplatten 64 und 65 größere Bohrlöcher vorgesehen, so daß die Fixierstifte 18 frei von den Leiterplatten mit einem Ansatz 69 in die entsprechende Bohrung der Platte 40 eingesetzt werden können. Der Ansatz 69 trägt dabei am freien Ende ein Gewinde, so daß der Fixierstift 18 mittels Unterlegscheibe 71 und Mutter 70 befestigt und gehalten werden kann.

FIG 8 zeigt eine der Ausrichtung der Schnittansicht von FIG 3C für die Lochplatte entsprechende Schnittansicht durch den oberen Teil der Prüfund Haltevorrichtung mit zweigeteilter Darstellung der beweglichen Platte 40 mit den Fixierstiften 18, den Federkontaktstiften 20 und den Führungsstiften 35 entsprechend den beiden möglichen Hubstellungen, wie sie auch den Teildarstellungen von FIG 6 und FIG 7 zugrunde liegt. Die Darstellung der linken Figurenhälfte bezieht sich dabei auf die Ausgangsstellung, während die Darstellung der rechten Figurenhälfte sich auf die Prüfraststellung bezieht.

In der Ausgangsraststellung sind die Schieber 32 durch die Zugfeder 37 bis zum Anschlag nach außen gezogen, so daß ihre Zungen nicht in die als Aufnahme für den Prüfling dienende Vertiefung 16 hineinragen. Lediglich die Fixierstifte 18 durchstoßen den Boden der Lochplatte 14 und ragen in die Vertiefung 16 hinein, so daß der Prüfling in Ausrichtung auf die Fixierstifte eingelegt werden kann. Die Spitzen der Führungsstifte 35 ragen nur geringfügig in die Bohrungen 30 der Schieber 32 hinein, und zwar im Bereich der Zunge zugewandten Bohrkante. Wird die bewegliche Platte 40 aus der gezeigten Ausgangsraststellung heraus nach oben bewegt, dann drückt die wie ein Keil wirkende Kegelspitze den Schieber mit zunehmender Hebebewegung zur Seite, da die Abdeckplatte 7 ein Ausweichen nach oben verhindert. Infolge dieser seitlichen Schiebewirkung bewegt sich der Schieber in Richtung auf die Aufnahmevertiefung 16, wobei die Zunge über den Trägerrücken des Prüflings gleitet. Parallel dazu verschieben sich auch die Fixierstifte 18 nach oben. Sobald die Kegelspitzen der Führungsstifte 35 in vollem Umfange in die Bohrungen 30 der Schieber 32 eingeführt sind, hat der Schieber seine Endstellung erreicht. Ein weiteres Anheben der beweglichen Platte 40 mit den Führungsstiften 35 hat damit keine Seitwärtsverlagerung der Schieber mehr zur Folge. Der danach verbleibende Resthub bis zum Erreichen der Prüfraststellung dient dazu, die an der beweglichen Platte 40 ebenfalls befestigten Kontaktstifte 20 auf die Anschlußbeine des Prüflings nach seiner räumlichen Fixierung durch die Fixierstifte 18 in Verbindung mit den Zungen der Schieber 32 aufzusetzen.

Insgesamt ergibt sich damit eine sehr einfach zu handhabende kompakte Halte- und Prüfvorrichtung, die in vielfältiger Form einsetzbar ist.

Abweichend von dem gezeigten Ausführungsbeispiel als eigenständige Einrichtung mit Betätigung von Hand kann die geiche Einrichtung auch in Prüftische einsetzbar ausgebildet werden, wobei der Trägerring zum Beispiel mit zusätzlichen Haltenasen oder einem Halteflansch versehen ist, der von unten oder oben an einer Prüftischplatte befestigt wird. Auch ein versenkter Einbau in eine Prüftischplatte ist ohne weiteres möglich, indem in diesem Falle die Lochplatte mit zusätzlichen Haltenasen oder einem Halteflansch zur Befestigung an der Prüftischplatte versehen wird. Auch kann ein Teil des Prüftisches als Abdeckplatte für die Lochplatte ausgebildet sein. Bei versenktem Einbau erfolgt die Betätigung der Stellwelle zweckmäßig durch eine pneumatisch arbeitende Stellvorrichtung.

Auch bezüglich des konstruktiven Aufbaus der Halte- und Prüfvorrichtung besteht eine Reihe von Variationsmöglichkeiten. Das betrifft in erster Linie die Gestaltung der Schieber und deren Bewegungssteuerung durch einen oder zwei Führungsstifte, sowie die Gestaltung des Wirkungseingriffs zwischen Führungsstift und Schieber zur Umsetzung der achsialen Längsverschiebung der Führungsstifte in eine dazu senkrechte Bewegung der Schieber mit Unterteilung
in zwei Bewegungsphasen, wobei nur während
der ersten eine Seitwärtsverschiebung der Schieber möglich ist. Analoges gilt für die Gestaltung
des Hebewerkes zur Umsetzung einer Drehbewegung in eine vertikale Verschiebebewegung für
die bewegliche Platte.

Andererseits wird die Anordnung der Fixierstifte und der Kontaktfederstifte in erster Linie
durch die verschiedenen Prüflinge bestimmt.
Soweit hierfür keine Überlagerungsmöglichkeiten
bestehen, weil die Fixierstifte unterschiedlich
anzuordnen sind oder weil das der Kontaktfederanordnung zugrunde liegende Anordnungsraster
nicht deckungsgleich ausgerichtet werden kann,
sind entsprechend abgewandelte unterschiedliche Halte- und Prüfvorrichtungen vorzusehen,
wobei in Verbindung mit dem einheitlichen Mehrfach-Koaxial-Verbindungs-Steckerteil    zum
Anschluß an die Meßvorrichtung ein Auswechseln erleichtert wird.

**Patentansprüche**

1. Halte- und Prüfvorrichtung für auf flache
Träger (2) aufgebrechte elektronische Bausteine
(22) mit in einer Ebene liegenden Anschlußbeinen
(23), wobei die Träger am Rande mit wenigstens
zwei Bohrungen bzw. Einbuchtungen (26) zur
Lagefixierung durch Fixierstifte (18) einer Aufnahme (13/16) versehen sind und eine gegenüber
der Aufnahme verschiebbare, auf einer beweglichen Platte (40) angebrachte Federkontaktanordnung (20) leitende Verbindungen zwischen den
einzelnen Anschlußbeinen (23) des jeweils zu
prüfenden Bausteines (22) und einer Meßeinrichtung herstellt, dadurch gekennzeichnet, daß die
bewegliche Platte (40) für die Federkontaktanordnung (20) gleichzeitig als Träger für die Fixierstifte
(18) und zusätzliche Führungsstifte (35) mit abgeschrägten Enden ausgebildet ist, die alle achsparallel zu den Federkontakten (20) angeordnet sind
und sich von der beweglichen Platte (40) aus in
derselben Richtung erstrecken,

daß die oberhalb der beweglichen Platte (40)
angebrachte Aufnahme (13/16) für die zu prüfenden Bausteine als Mulde in einer Lochplatte (14)
ausgebildet ist, die den einzelnen Federkontakten
(20) der Kontaktanordnung, den Fixierstiften (18)
und den Führungsstiften (35) entsprechende
Durchbrüche (19 bzw. 17 bzw. 34) aufweist,

daß in einer Ausgangsraststellung die Enden
der Fixierstifte (18) durch die entsprechenden
Durchbrüche (17) der Lochplatte (14) hindurchragen und in die Bohrungen bzw. Einbuchtungen
(26) des in die Mulde eingelegten Trägers (21)
eingreifen,

daß in die Lochplatte (14) zwei in der Horizontalen verschiebbare Schieber (32) mit wenigstens
einer Eingriffsöffnung (z.B. Bohrung (30) für die
Führungsstifte (35) eingelassen sind, die in der
Ausgangsraststellung mit ihren Spitzen jeweils an
der Kante der jeweils zugehörigen Eingriffsöffnung (30) anliegen, so daß beim vertikalen Verschieben der Führungsstifte (35) die Schieber (32)
in der Horizontalen aufeinander zu bewegbar
sind,

daß an den Schiebern (32) seitliche Zungen (33)
angebracht sind, die beim Verschieben der Schieber (32) über den Träger (21) des zu prüfenden
Bausteines (22) gleiten und diesen in Verbindung
mit den Fixierstiften (18) lagerichtig fixieren,
bevor durch eine weitere Bewegung der beweglichen Platte (40) in die Prüfraststellung die elektrischen Verbindungen mit den einzelnen Anschlußbeinen (23) des zu prüfenden Bausteines (22)
durch die Federkontakte (20) der Federkontaktanordnung herstellbar sind.

2. Halte- und Prüfvorrichtung nach Anspruch 1,
dadurch gekennzeichnet, daß die bewegliche
Lochplatte (40) aus einem zentralen viereckigen
Plattenteil (42) mit sich jeweils horizontal erstrekkenden Erweiterungen an den vier Ecken besteht,
von denen zwei einander diagonal gegenüberliegende Erweiterungen mit in Bohrungen (43) eingesetzten Linearkugellagern (44) versehen sind,
über die die bewegliche Platte (40) längs Führungsstäben (15) in vertikaler Richtung verschiebbar ist, während die beiden anderen, ebenfalls
einander diagonal gegenüberliegenden Erweiterungen mit Verbindungselementen (46, 60) einer
Antriebsvorrichtung (z.B. Welle 10) gekoppelt
sind.

3. Halte- und Prüfvorrichtung nach Anspruch 2,
dadurch gekennzeichnet, daß die Antriebsvorrichtung aus einer horizontal gelagerten Welle (10)
besteht, auf der entsprechend den beiden Erweiterungen der beweglichen Platte (40) für die
Verstellung zwei Nockenscheiben (59) befestigt
sind, und daß die Nockenscheiben (59) mit der
beweglichen Platte (40) jeweils durch eine an
beiden Enden drehbar befestigte Führungsstange
(60) verbunden sind, so daß durch Drehen der
Welle (10) die bewegliche Platte (40) in der Senkrechten entlang den Führungsstäben (15) verschiebbar ist.

4. Halte- und Prüfvorrichtung nach Anspruch 3,
dadurch gekennzeichnet, daß wenigstens eine
der beiden Lagerungen (55) für die Welle (10) mit
zwei Anschlagzapfen (63) für die zugehörige Nokkenscheibe (59) zur Begrenzung der Drehbewegungen und damit der Hubbewegungen der
beweglichen Platte (40) versehen ist.

5. Halte -und Prüfvorrichtung nach Anspruch 4,
dadurch gekennzeichnet, daß wenigstens eine
der beiden Nockenscheiben (59) am Rande zwei
Einbuchtungen (61) aufweist, in die ein entsprechend gewölbtes Teil einer Feder (62) rastend in
Abstimmung mit der Begrenzung der Wellendrehbewegung zur Festlegung der Ausgangsraststellung und der Prüfraststellung eingreift.

6. Halte- und Prüfvorrichtung nach einem der
Ansprüche 3 bis 5, dadurch gekennzeichnet, daß
die Führungsstäbe (15) für die bewegliche Platte
(40) jeweils an einem Ende mit der Lochplatte (14)
starr verbunden sind, daß die anderen Enden der
Führungsstäbe (15) zusammen mit den Lagerungen (55) für die Welle (10) an einem gemeinsamen Trägerelement (4) befestigt sind und daß alle so miteinander verbundenen Vorrichtungselemente ein einheitliches Bauteil bilden.

7. Halte- und Prüfvorrichtung nach Anspruch 6, dadurch gekennzeichnet, daß das gemeinsame Trägerelement als Adapterrring (4) zur Befestigung an einem Mehrfach-Koaxialverbindungs-Steckerteil (1) ausgebildet ist, über das die Verbindung mit der Meßeinrichtung herstellbar ist.

8. Halte- und Prüfvorrichtung nach Anspruch 6 oder 7, dadurch gekennzeichnet, daß die Lochplatte (14) als Einsatz eines Prüftisches ausgebildet ist.

9. Halte- und Prüfvorrichtung nach Anspruch 6 oder 7, dadurch gekennzeichnet, daß die Lochplatte (14) an einem als Abdeckplatte dienenden Teil eines Prüftisches befestigt ist.

10. Halte- und Prüfvorrichtung nach Anspruch 7, dadurch gekennzeichnet, daß der Adapterring (4) als Befestigung an einem Prüftisch ausgebildet ist und das vom Adapterring getragene einheitliche Bauteil sich über die Prüftischfläche erhebt.

11. Halte- und Prüfvorrichtung nach einem der Ansprüche 6 bis 10, dadurch gekennzeichnet, daß an der Welle (10) ein Handhebel (11) zur Betätigung von Hand angebracht ist.

12. Halte- und Prüfvorrichtung nach Anspruch 11, in Verbindung mit Anspruch 7 oder 10, dadurch gekennzeichnet, daß das einheitliche Bauteil in einer Gehäusehülse (6) untergebracht ist, die von der Seite der ebenfalls kreisförmig ausgebildeten Lochplatte (14) her aufgeschoben und vom Adapterring (4) sowie einer die Hülse (6) überdeckenden Abdeckplatte (7) gehalten wird.

13. Halte- und Prüfvorrichtung nach einem der Ansprüche 8 bis 10, dadurch gekennzeichnet, daß die Welle (10) über einen Hebel mit einer pneumatisch arbeitenden Stellvorrichtung gekoppelt ist.

14. Halte- und Prüfvorrichtung nach einem der Ansprüche 1 bis 13, dadurch gekennzeichnet, daß oberhalb und unterhalb der beweglichen Platte (40) je eine gedruckte Leiterplatte (65, 64) befestigt ist, die mit Bohrungen (47) für die Federkontaktstifte (20) jeweils konzentrisch fluchtende Bohrungen aufweisen, in die die Bohrungen durchdringende Hülsen (68) für die Kontaktstifte (20) jeweils fest eingelötet sind.

15. Halte- und Prüfvorrichtung nach Anspruch 14, dadurch gekennzeichnet, daß die beiden Leiterplatten (64, 65) den viereckigen zentralen Plattenteil (42) in den Bereichen zwischen den Erweiterungen an den Ecken überragen und daß in diesen überdeckungsfreien Bereichen der Leiterplatten Koaxial-Kabel-Übergänge (67) in durch Leiterbahnen mit den Kontaktstiften (20) verbundene Bohrungen eingelötet sind.

16. Halte- und Prüfvorrichtung nach einem der Ansprüche 1 bis 15, dadurch gekennzeichnet, daß die Schieber (32) mit ihren Zungen (33) eine einheitliche Breite aufweisen und daß die Schieber (32) jeweils mit einem Führungsstift (35) im Wirkungseingriff stehen.

17. Halte- und Prüfvorrichtung nach einem der Ansprüche 1 bis 15, dadurch gekennzeichnet, daß die Schieber (32) gegenüber den Zungen (33) eine wesentlich größere Breite aufweisen und daß die Schieber (32) jeweils mit zwei Führungsstiften (35) im Wirkungseingriff stehen.

18. Halte- und Prüfvorrichtung nach Anspruch 16 oder 17, dadurch gekennzeichnet, daß die Eingriffsöffnungen (30) der Schieber (32) und die abgeschrägten Enden der Führungsstifte (35) konstruktiv so aufeinander abgestimmt sind, daß während einer ersten Bewegungsphase der beweglichen Platte (40) von den Führungsstiften (35) auf die Schieber (32) jeweils eine die horizontale Verschiebung bewirkende Kraft ausgeübt wird, während während einer anschließenden zweiten Bewegungsphase die weitere vertikale Bewegung der Führungsstifte (35) ohne Auswirkung bleibt, und daß die Schieber (32) jeweils mit einer Zugfeder (37) zur Rückführung der Schieber in die Ausgangslage verbunden sind.

19. Halte- und Prüfvorrichtung nach Anspruch 18, dadurch gekennzeichnet, daß die Eingriffsöffnungen (30) der Schieber (32) als Bohrlöcher mit kreisrundem Querschnitt ausgebildet sind und daß die Führungsstifte (35) gleichfalls einen im Querschnitt der Bohrlöcher (30) angepaßten Querschnitt aufweisen, der sich zum Ende hin kegelförmig verjüngt.

**Revendications**

1. Dispositif de maintien et de contrôle pour des composants électroniques (22) montés sur des supports plats (21) et comportant des pattes de branchement 23 qui se situent dans un plan, les supports étant pourvus sur le bord d'au moins deux perçages ou cuvettes (26) pour la fixation en position, à l'aide de chevilles de fixation (18), d'un moyen de réception (13/16), alors qu'un dispositif à contacts élastiques (20) monté sur une plaque mobile (40) et déplaçable par rapport au moyen de réception, établit des liaisons conductrices entre les différentes pattes (23) du module à contrôler (22) et un dispositif de mesure, caractérisé par le fait

que la plaque mobile (40) pour le dispositif à contacts élastiques (20) est réalisée pour servir à la fois de support pour les chevilles de fixation (18) et pour des chevilles supplémentaires de guidage (35) à extrémités biseautées, disposées, tous, parallèlement à l'axe des contacts élastiques (20) et s'étendent dans la même direction à partir de la plaque mobile (40),

que le dispositif de réception (13/16) pour les modules à contrôler, qui est monté au-dessus de la plaque mobile (40), est réalisé sous la forme d'une auge ménagée dans une plaque perforée (14) qui comporte des ouvertures (19, 17, 34 respectivement) qui correspondent aux différents contacts élastiques (20) du dispositif à contacts, aux chevilles de fixation (18) et aux chevilles de guidage (35),

que dans une position initiale d'enclenchement, les extrémités des chevilles de fixation (18) passent à travers les ouvertures correspondantes (17) de la plaque perforée (14) et pénètrent dans les perçages ou cuvettes (26) du support (21) placé dans l'auge,

que dans la plaque perforée (14) sont engagés deux coulisses (32) déplaçables horizontalement et comportant au moins un ouverture de pénétration (par exemple un perçage 30) pour les chevilles de guidage (35) qui portent, dans la position initiale d'enclenchement, par leurs pointes, respectivement contre le bord de l'ouverture de pénétration respective (30), de manière que lors du déplacement vertical des chevilles de guidage (35), les coulisses se déplacent horizontalement l'une par rapport à l'autre,

que les coulisses (32) sont pourvues de languettes latérales (33) qui, lors du déplacement des coulisses (32) glissent au-dessus du support (21) de module à contrôler et fixent ce dernier en position correcte, en liaison avec les chevilles de fixation (18), avant que, par suite d'un déplacement ultérieur de la plaque mobile (40) dans la position d'enclenchement de contrôle, soient établies les liaisons électriques avec les différentes pattes de branchement (23) du module (22) à contrôler, à l'aide des contacts élastiques (20) du dispositif à contacts élastiques.

2. Dispositif de maintien et de contrôle selon la revendication 1, caractérisé par le fait que la plaque perforée mobile (40) est constituée par un élément de plaque quadrangulaire (42) comportant, aux quatre sommets, des prolongements qui s'étendent horizontalement, et parmi lesquels deux prolongements qui se situent diagonalement l'un en face de l'autre sont pourvus de roulements à billes linéaires (44) insérés dans des perçages (43), et par l'intermédiaire desquels la plaque mobile (40) est susceptible d'être déplacée dans le sens vertical, le long de tiges de guidage (15), alors que les deux autres prolongements qui se situent également diagonalement l'un en face de l'autre, sont couplés à des éléments de liaison d'un dispositif d'entraînement (par exemple un arbre 10).

3. Dispositif de maintien et de contrôle selon la revendication 2, caractérisé par le fait que le dispositif d'entraînement est constitué par un arbre (10) monté horizontalement, et sur lequel sont fixés, en correspondance aux deux prolongements de la plaque mobile (40), deux disques à cames (59) qui servent aux déplacements, et que les disques à cames (59) sont chacun reliés à la plaque mobile (40) par une tige de guidage (60) qui est fixée, à rotation, aux deux extrémités, si bien que par la rotation de l'arbre (10), la plaque mobile (40) est susceptible d'être déplacée, dans le sens vertical, le long des tiges de guidage (15).

4. Dispositif de maintien et de contrôle selon la revendication 3, caractérisé par le fait qu'au moins l'un des deux paliers (55) pour l'arbre (10), est pourvu de deux butées (63) pour le disque à cames associé (59), en vue de limiter le mouvement de rotation et, par voie de conséquence, les déplacements vers le haut de la plaque mobile (40).

5. Dispositif de maintien et de contrôle selon la revendication 4, caractérisé par le fait qu'au moins l'un des deux disques à cames (59) comporte, à la périphérie, deux creux (61) dans lesquels pénètre une partie à courbure correspondante d'un ressort (62), avec enclenchement, et en accord avec la limitation du mouvement de rotation de l'arbre en vue de déterminer la position de départ et la position d'enclenchement pour le contrôle.

6. Dispositif de maintien et de contrôle selon l'une des revendications 3 à 5, caractérisé par le fait que chacune des tiges de guidage (15) pour la plaque mobile (40), est reliée rigidement, à une extrémité, avec la plaque perforée (14), que les autres extrémités des tiges de guidage (15), y compris les paliers (55) pour l'arbre (10), sont fixées à un élément de support commun (4), et que tous les éléments du dispositif, ainsi reliés entre eux, constituent un élément de construction unitaire.

7. Dispositif de maintien et de contrôle selon la revendication 6, caractérisé par le fait que l'élément de support commun est réalisé sous la forme d'une bague d'adaptation (4) pour la fixation à un élément à enfichage et à liaisons coaxiales multiples, élément par l'intermédiaire duquel est susceptible d'être établie la liaison avec le dispositif de mesure.

8. Dispositif de maintien et de contrôle selon la revendication 6 ou 7, caractérisé par le fait que la plaque perforée (14) est réalisée sous la forme d'un élément d'insertion d'une table de contrôle.

9. Dispositif de maintien et de contrôle selon la revendication 6 ou 7, caractérisé par le fait que la plaque perforée (14) est fixée à un élément de la table de contrôle, qui sert de couvercle.

10. Dispositif de maintien et de contrôle selon la revendication 7, caractérisé par le fait que la bague d'adaptation (4) est réalisée pour la fixation à une table de contrôle, et que l'élément de construction unitaire qui est porté par la bague d'adaptation, s'étend au-dessus de la surface de la table de contrôle.

11. Dispositif de maintien et de contrôle selon l'une des revendications 6 à 10, caractérisé par le fait qu'à l'arbre (10) est fixé un levier (11) destiné à être actionné à la main.

12. Dispositif de maintien et de contrôle selon la revendication 11, en liaison avec la revendication 7 ou 10, caractérisé par le fait que l'élément de construction unitaire est logé dans une douille-enveloppe (6) qui est engagée à partir du côté de la plaque perforée (14) qui est également de forme circulaire, et qui est maintenue par la bague d'adaptation (4) ainsi que par un couvercle (7) recouvrant la douille (6).

13. Dispositif de maintien et de contrôle selon l'une des revendications 8 à 10, caractérisé par le fait que l'arbre (10) est accouplé, par l'intermédiaire d'un levier, à un dispositif de réglage qui opère par voie pneumatique.

14. Dispositif de maintien et de contrôle selon l'une des revendications 1 à 13, caractérisé par le fait que respectivement au-dessus et en-dessous de la plaque mobile (40) est fixée une plaquette à circuits imprimés (65, 64) qui comporte, en alignement concentrique avec les perçages (47) pour les chevilles de contact élastique (20), des perçages dans lesquels sont soudées respectivement les douilles (68) pour les chevilles de contact (20), qui traversent lesdits perçages.

15. Dispositif de maintien et de contrôle selon la revendication 14, caractérisé par le fait que les deux plaquettes à circuits imprimés (64, 65) débordent l'élément de plaques quadrangulaire et centrale (42) dans les zones qui se situent entre les prolongements prévus aux sommets, et que dans ces zones des plaquettes à circuits imprimés, qui sont dépourvues d'une quelconque couverture, sont soudées des transitions à câble coaxial (67), dans des perçages qui sont reliés aux chevilles de contact (20) par l'intermédiaire des pistes conductrices.

16. Dispositif de maintien et de contrôle selon l'une des revendications 1 à 15, caractérisé par le fait que les coulisseaux ou coulisses (32) présentent, avec leurs languettes (33), une largeur uniforme, et que les coulisses (32) coagissent respectivement avec une cheville de guidage (33).

17. Dispositif de maintien et de contrôle selon l'une des revendications 1 à 15, caractérisé par le fait que les coulisses ou coulisseaux (32) présentent, par rapport aux languettes (33), une largeur notablement plus grande, et que les coulisses ou coulisseaux (32) coagissent, respectivement, avec deux chevilles de guidage (35).

18. Dispositif de maintien et de contrôle selon la revendication 16 ou 17, caractérisé par le fait que les ouvertures de pénétration (30) des coulisses ou coulisseaux (32) et les extrémités biseautées des chevilles de guidage (35) sont adaptées, du point de vue de la construction, de telle façon entre eux, que pendant une première phase de mouvement de la plaque mobile (40) les chevilles de guidage (35) exercent sur les coulisses ou coulisseaux (32), respectivement une force qui agit dans le sens d'un déplacement horizontal, alors que pendant la seconde phase de déplacement qui y fait suite, le déplacement ou mouvement vertical des chevilles de guidage (33) sont sans effet, et que les coulisses ou coulisseaux (32) sont chacun reliés à un ressort de traction (37) pour le renvoi des coulisses ou coulisseaux dans la position de départ.

19. Dispositif de maintien et de contrôle selon la revendication 18, caractérisé par le fait que les ouvertures de pénétration (30) des coulisses ou coulisseaux (32) sont réalisées sous la forme de perçages au foret, à section ronde, et que les chevilles de guidage (35) présentent également, une section transversale qui est adaptée à la section transversale des perçages (30), section transversale qui s'amincit coniquement vers l'extrémité.

**Claims**

1. Holding and testing device for electronic components (22) mounted on flat supports (21) and having connecting legs (23) lying in a plane, it being the case that the supports are provided at the edge with at least two bores or recesses (26) for fixing their position by means of alignment pins (18) of a receptor (13/16) and that a spring contact arrangement (20) that is displaceable with respect to the receptor and is attached to a movable plate (40) produces conductive connections between the individual connecting legs (23) of the particular component (22) to be tested and a measuring device, characterized in that the movable plate (40) for the spring contact arrangement (20) is constructed at the same time as a support for the alignment pins (18) and additional guide pins (35) with bevelled ends, which are all arranged axially parallel to the spring contacts (20) and extend outwards from the movable plate (40) in the same direction,

in that the receptor (13/16) for the components to be tested that is attached above the movable plate (40) is constructed as a depression in an aperture plate (14), which has through holes (19 or 17 or 34) corresponding to the individual spring contacts (20) of the contact arrangement, the alignment pins (18) and the guide pins (35),

in that in an initial rest position the ends of the alignment pins (18) project through the corresponding through holes (17) of the aperture plate (14) and engage in the bores or recesses (26) of the support (21) inserted into the depression,

in that two horizontally displaceable slides (32) with at least one engagement opening (e.g. bore 30) for the guide pins (35) are admitted into the aperture plate (14), which slides bear, when in their initial rest position, with their tips against the edge of the particular associated engagement opening (30), so that in the case of vertical displacement of the guide pins (35) the slides (32) can be moved horizontally towards one another, and

in that lateral tongues (33) are provided on the slides (32), which tongues slide, when the slides (32) are displaced, over the support (21) of the component (22) to be tested and fix the latter in its correct position in conjunction with the alignment pins (18), before by a further movement of the movable plate (40) into the testing rest position the electrical connections with the individual connecting legs (23) of the component (22) to be tested can be produced by the spring contacts (20) of the spring contact arrangement.

2. Holding and testing device according to Claim 1, characterized in that the movable aperture plate (40) consists of a central quadrangular plate part (42) with expansions extending horizontally in each case at the four corners, of which two expansions diagonally opposite one another are provided with linear ball bearings (44), installed in bores (43), via which bearings the movable plate (40) can be displaced in the vertical direction along guide rods (15), while the two other expansions, which are likewise diagonally opposite one another, are coupled with connecting elements (46, 60) of a drive device (e.g. shaft 10).

3. Holding and testing device according to Claim 2, characterized in that the drive device consists of a horizontally supported shaft (10) on which two cam discs (59) are fastened for the adjustment in conformity with the two expansions of the movable plate (40), and in that the cam discs (59) are connected in each case to the movable plate (40) by a guide bar (60) fastened rotatably to both ends, so that the movable plate (40) can be displaced vertically along the guide rods (15) by rotating the shaft (10).

4. Holding and testing device according to Claim 3, characterized in that at least one of the two bearings (55) for the shaft (10) is provided with two stop pins (63) for the associated cam disc (59) to limit the rotary movements and thus the stroke movements of the movable plate (40).

5. Holding and testing device according to Claim 4, characterized in that at least one of the two cam discs (59) has two recesses (61) at the edge, in which a correspondingly humped part of a spring (62) engages at rest in coordination with the limitation of the rotary movement of the shaft to fix the initial rest position and the testing rest position.

6. Holding and testing device according to one of Claims 3 to 5, characterized in that the guide rods (15) for the movable plate (40) are rigidly connected in each case at one end to the aperture plate (14), in that the other ends of the guide rods (15) are fastened together with the bearings (55) for the shaft (10) to a common support element (4), and in that all the elements of the device thus connected to one another form a uniform structural part.

7. Holding and testing device according to Claim 6, characterized in that the common support element is constructed as an adaptor ring (4) for fastening to a multiple coaxial connection plug part (1), via which the connection to the measuring device can be made.

8. Holding and testing device according to Claim 6 or 7, characterized in that the aperture plate (14) is constructed as an insert of a test bench.

9. Holding and testing device according to Claim 6 or 7, characterized in that the aperture plate (14) is fastened to a test bench part serving as a covering plate.

10. Holding and testing device according to Claim 7, characterized in that the adaptor ring (4) is constructed as a fastening on a test bench, and the uniform structural part supported by the adaptor ring rises above the test bench surface.

11. Holding and testing device according to one of Claims 6 to 10, characterized in that a hand lever (11) is attached for operation by hand to the shaft (10).

12. Holding and testing device according to Claim 11, in conjunction with Claim 7 or 10, characterized in that the uniform structural part is accommodated in a housing shell (6) which is pushed on from the side of the aperture plate (14), which is likewise constructed to be circular, and is held by the adaptor ring (4) and by a covering plate (7) which covers the shell (6).

13. Holding and testing device according to one of Claims 8 to 10, characterized in that the shaft (10) is coupled via a lever with a pneumatically operating adjusting device.

14. Holding and testing device according to one of Claims 1 to 13, characterized in that one printed circuit board (65, 64) each is fastened above and below the movable plate (40), which have bores, which are each aligned concentrically with the bores (47) for the spring contact pins (20) and in which sleeves (68), penetrating the bores, for the contact pins (20) are firmly soldered in each case.

15. Holding and testing device according to Claim 14, characterized in that the two circuit boards (64, 65) rise above the quadrangular central plate part (42) in the regions between the expansions at the corners, and in that in these non-overlapped regions of the circuit boards coaxial cable terminals (67) are soldered in bores connected via printed conductors to the contact pins (20).

16. Holding and testing device according to one of Claims 1 to 15, characterized in that the slides (32) including their tongues (33) are of uniform width, and in that the slides (32) are each in operational engagement with a guide pin (35).

17. Holding and testing device according to one of Claims 1 to 15, characterized in that by comparison with the tongues (33) the slides (32) have a substantially larger width, and in that the slides (32) are each in operational engagement with two guide pins (35).

18. Holding and testing device according to Claim 16 or 17, characterized in that the engagement openings (30) of the slides (32) and the bevelled ends of the guide pins (35) are coordinated structurally with one another in such a way that during a first movement phase of the movable plate (40) from the guide pins (35) to the slides (32) a force effecting the horizontal displacement is exercised in each case, while during a subsequent second movement phase the further vertical movement of the guide pins (35) remains without effect, and in that the slides (32) are each connected to a tension spring (37) for returning the slides into the initial position.

19. Holding and testing device according to Claim 18, characterized in that the engagement openings (30) of the slides (32) are constructed as bore holes with a circular cross-section, and in that the guide pins (35) likewise have a cross-section, which is matched with the cross-section of the bore holes (30) and tapers conically towards the end.

## FIG 1B

## FIG 1A

## FIG 1C

## FIG 2B

## FIG 2A

# FIG 3C

# FIG 3B

# FIG 3A

## FIG 4B

45      44      46

## FIG 4A

40    44    35    C

47

45    VIII

1    1

46    45

VIII    42

44

35    43

35

47

35    44

## FIG 4C

# FIG 5C

# FIG 5B

# FIG 5A

FIG 8

FIG 7A

FIG 7B

FIG 6A

FIG 6B

FIG 9

FIG 10